# FASCICULE DE BREVET EUROPEEN

(11) **EP 0 519 805 B1**
(45) Date de publication et mention de la délivrance du brevet: **10.01.1996**
(21) Numéro de dépôt: 92401671.0
(22) Date de dépôt: 16.06.1992
(51) Int. Cl.: H02J 7/16, G01R 19/165, G01R 19/00

(54) **Détection de la tension entre phases dans un régulateur d'alternateur**
Regler mit Messung der Spannung zwischen den Phasen in einem Drehstromgenerator
Detection of the voltage between phases in an alternator-regulator

(30) Priorité: 18.06.1991 FR 9107436
(43) Date de publication de la demande: 23.12.1992
(73) Titulaire: VALEO EQUIPEMENTS ELECTRIQUES MOTEUR, F-94000 Creteil (FR); SGS-THOMSON MICROELECTRONICS S.r.l., I-20041 Agrate Brianza (Milano) (IT)
(72) Inventeur: Pennisi, Alessio, I-20149 Milan (IT); Marchio, Fabio, I-21013 Gallarate (IT); Pierret, Jean-Marie, F-75012 Paris (FR); Canitrot, Didier, F-94100 Saint-Maur des Fosses (FR)
(74) Mandataire: Martin, Jean-Jacques

(56) Documents cités:
- EP-A- 0 191 571
- EP-A- 0 408 436
- GB-A- 2 159 286

## Description

La présente invention concerne un circuit de détection du signal phase d'un alternateur polyphasé pour la mise en service d'un circuit de régulation de la charge d'une batterie de véhicule par cet alternateur lorsque ce dernier entre en rotation.

Un tel circuit fait l'objet de la demande de brevet européen publiée n° 0 408 436 au nom de la demanderesse.Cette demande expose en détail les avantages d'un tel type de détection, en particulier en matière de comptabilité de câblage entre divers types d'installations.Plus précisément, ce document enseigne un circuit de détection conforme au préambule de la revendication 1.

Le principe de cette détection est basé sur le fait que la mise en rotation de l'alternateur provoque l'apparition entre deux bornes de phases de celui-ci d'une certaine tension. La demande de brevet précitée décrit un mode de réalisation dans lequel la tension entre phases précitée est comparée avec une tension de seuil, par exemple de +0,6 volts. Lors du franchissement de ce seuil, une sortie logique du circuit change alors d'état pour activer le circuit de régulation et ainsi appliquer à l'enroulement d'excitation de l'alternateur le courant de régulation approprié.

La présente invention vise en premier lieu à proposer un circuit qui, d'une manière extrêmement simple et économique, améliore la fiabilité de la détection de la tension entre phases.

Par ailleurs, le circuit connu précité présente un certain nombre de limitations. En particulier, son immunité vis-à-vis de signaux parasites notamment dans le domaine des radiofréquences est perfectible. En outre, la situation de défaut selon laquelle une liaison entre l'alternateur et l'une ou l'autre des entrées pour signaux de phase est coupée ne peut pas être détectée de façon fiable par ce circuit.

Dans les deux cas, il peut en résulter une mise en service du régulateur alors que l'alternateur ne tourne pas (moteur à l'arrêt), ce qui conduit en particuler à une décharge de la batterie du véhicule.

La présente invention vise également à pallier ces limitations sans accroître la complexité ou le coût du circuit.

Ainsi l'invention concerne un circuit de détection tel que défini dans la revendication 1.

Des aspects préférés, mais non limitatifs, de ce circuit sont exposés dans les sous-revendications.

D'autres aspects, buts et avantages de la présente invention apparaîtront mieux à la lecture de la description détaillée suivante de formes de réalisation préférées de celle-ci, donnée à titre d'exemple non limitatif et faite en référence aux dessins annexés, sur lesquels:
la figure 1 est un schéma électrique d'un circuit selon une première forme de réalisation de l'invention, et
la figure 2 est un schéma électrique d'un circuit selon une deuxième forme de réalisation de l'invention.

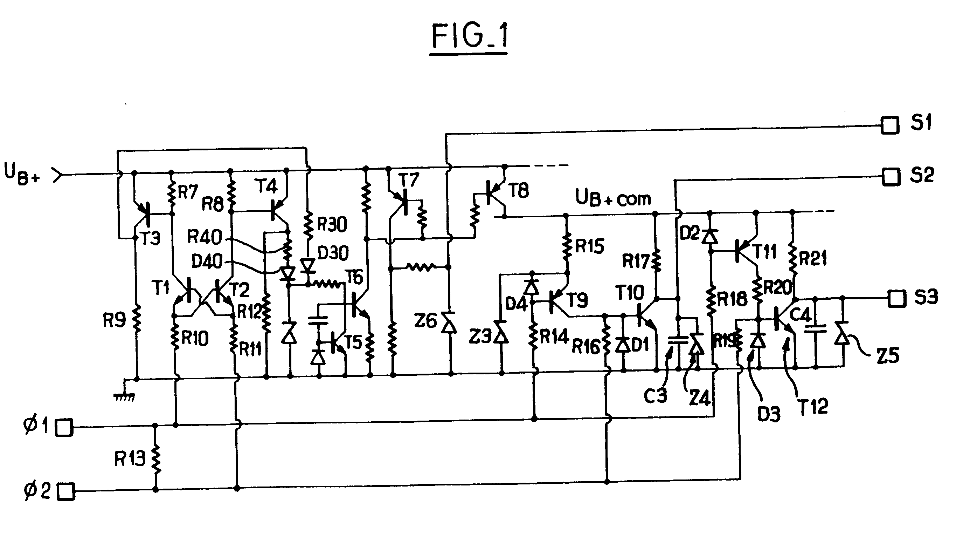

En référence tout d'abord à la figure 1, on a représenté un circuit de détection selon l'invention qui comprend deux bornes d'entrée pour des signaux ø1 et ø2 provenant de deux phases de l'alternateur. Ces deux bornes sont reliées entre elles par une résistance R13. La borne φ1 est reliée via une résistance R10 à l'émetteur d'un transistor NPN T1 et à la base d'un transistor NPN T2. La borne ø2 est reliée via une résistance R11 à la base de T1 et à l'émetteur de T2. Les transistors T1 et T2 comportent des résistances de collecteur R7 et R8, respectivement, entre leur collecteur et une ligne d'alimentation sous une tension U_{B+} reliée au pôle positif de la batterie du véhicule.

Les collecteurs de T1 et T2 attaquent les bases de deux transistors PNP T3 et T4. Les émetteurs de T3 et T4 sont tous deux reliés à la ligne U_{B+}, tandis que leurs collecteurs sont reliés à la masse via des résistances respectives R9, R12.

Les collecteurs de T3 et T4 sont en outre reliés à un circuit de traitement via deux résistances respectives R30 et R40 et deux diodes D30, D40, constituant une porte OU.

Le circuit de traitement, construit autour de T5, T6 et T7 montés en cascade, est un circuit discriminateur de rapport cyclique du type intégrateur de Miller, tel que décrit et représenté sur la figure 4b de la demande de brevet français No. 2 649 797, à laquelle on se reportera pour davantage de détails.

Une borne de sortie logique S1 est reliée via une résistance au collecteur de T7. Cette sortie S1 est appliquée au régulateur (non représenté) pour provoquer la mise en service de celui-ci lorsqu'un niveau logique haut est présent sur cette sortie.

Un transistor T8 a sa base reliée au collecteur de T6 via une résistance. Son émetteur est relié à la ligne U_{B+} tandis que son collecteur est relié à une ligne d'alimentation commutée U_{B+com}.

La borne ø1 est par ailleurs reliée via une résistance R14 à la base d'un transistor PNP T9. Le collecteur de T9 est relié à la borne ø2 via une résistance R16. L'émetteur de T9 est relié de première part à une ligne d'alimentation U_{B+com} via une résistance R15, de deuxième part à la cathode d'une diode D4 et de troisième part à la cathode d'une diode zéner Z3. L'anode de D4 est reliée à la base de T9. L'anode de Z3 est reliée à la masse.

Le collecteur de T9 est en outre reliée à la base d'un transistor NPN T10 et à la cathode d'une diode D1. L'anode de D1 est à la masse. Une résistance R17 est prévue entre le collecteur de T10 et la ligne U_{B+com}, tandis que son émetteur est à la masse. Le collecteur de T10 est par ailleurs relié à une borne de sortie logique S2 du circuit, ainsi qu'à des premières bornes respectives d'un condensateur C3 et d'une diode zéner Z4 montées en parallèle entre ledit collecteur et la masse.

La borne d'entrée ø1 est par ailleurs reliée via une résistance R18 à la base d'un transistor PNP T11. Cette base est également reliée à l'anode d'une diode D2 dont la cathode est reliée à la ligne U_{B+com}. L'émetteur de T11 est relié à cette même ligne, tandis que son collecteur est relié à une première borne d'une résistance R20. La seconde borne de R20 est reliée de première part à une première borne d'une résistance R19, de deuxième part à la cathode d'une diode D3 et de troisième part à la base d'un transistor NPN T12. La seconde borne de R19 est reliée à la borne ø2. L'anode de D3 est à la masse, tout comme l'émetteur de T12. Son collecteur est relié à la ligne U_{B+com} via une résistance R21 et à une borne de sortie logique S3. Par ailleurs un condensateur C4 et une diode zéner Z5 sont montées en parallèle entre le collecteur de T12 et la masse.

On va maintenant décrire le fonctionnement du circuit de détection de la figure 1.

Les transistors T1 et T2 ont pour objet de comparer la tension entre phases notée V_{ø2-Vø1} à deux valeurs de seuil déterminées qui sont définies par les tensions de jonction émetteur/base de T1 et T2. Ces deux valeurs de seuils sont par exemple de +0,6 volt (pour T1) et de -0,6 volt (pour T2).

Les transistors T3 et T4 sont des transistors de mise en forme des signaux engendrés par T1 et T2 lorsque les seuils précités sont franchis.

Pendant que V_{ø2-}V_{ø1} a une valeur positive supérieure à +0,6 volt, T1 et T3 sont passants et T2 et T4 sont bloqués. Inversement, dès que V_{ø2-}V_{ø1} a une valeur négative inférieure à -0,6 volt, T2 et T4 sont passants et T1 et T3 sont bloqués. Et lorsque V_{ø2-}V_{ø1} a une valeur comprise entre -0,6 volt et +0,6 volt, T1, T2, T3 et T4 sont bloqués.

L'intégrateur de Miller reçoit des signaux logiques des transistors T3 et T4. En rejetant les signaux de détection de franchissement de seuil, correspondant à T3 ou T4 passant, qui ont un faible rapport cyclique par rapport aux durées pendant lesquelles le même transistor est bloqué, on évite de faire passer la sortie S1 dans un état d'activation du circuit régulateur associé à l'alternateur lorsqu'apparaissent dans la tension entre phases de brefs signaux parasites ou encore des impulsions à haute fréquence liées à des transitoires de commutation.

Inversement, lorsque l'une ou l'autre de ces tensions de seuil est franchie avec un rapport cyclique substantiel, cela signifie que l'alternateur du véhicule est en rotation et qu'il faut mettre le régulateur en fonctionnement. Cette mise en fonctionnement s'effectue par passage de la sortie logique S1 au niveau haut via l'intégrateur de Miller.

La présente invention est avantageuse en ce qu'elle permet d'effectuer une double comparaison de la tension entre phases, avec deux tensions de seuil respectivement positive et négative, à l'aide d'un circuit à deux transistors T1 et T2 extrêmement simple et économique, facilement intégrable et occupant dans ce cas une très faible surface de silicium. On observe en outre que ces deux transistors, ainsi que T3 et T4, peuvent être branchés directement sur la tension de batterie U_{B+}. En effet, à l'état de repos de l'alternateur, tous ces transistors sont fermés la majeure partie du temps, voire en permanence en l'absence de parasites ou de transitoires de commutation, et le courant qu'ils consomment est négligeable.

La partie du circuit construite autour de T9 et T10 a pour objet d'assurer que, lorsque l'alternateur est en rotation, le signal alternatif de phase ø2 franchit au niveau de ses crêtes respectivement deux tensions de seuil déterminées, par exemple de +0,6 volt et de +7 volts. Cette condition est en effet nécessaire, de façon classique en soi, pour assurer le bon fonctionnement d'un compte-tours électronique équipant le véhicule et branché sur cette sortie phase, en particulier dans le cas des moteurs diesel.

Plus précisément, dans le cas où la tension sur la borne ø1 est supérieure à la tension de la diode zéner Z3 diminuée de la tension de jonction émetteur-base de T9 (soit la valeur de +7 volts citée à titre d'exemple), alors T9 est bloqué. Si pendant ce temps la tension sur ∅2 est inférieure à la tension de jonction émetteur-base de T10, alors T10 est bloqué. La sortie S2 est donc à un niveau logique haut, ce qui signale que les crêtes franchissent les seuils et que le compte-tours pourra fonctionner normalement. En revanche, dès que l'une des deux conditions ci-dessus n'est pas remplie, T10 devient passant pour faire passer la sortie S2 au niveau logique bas. Ceci aura pour effet, de façon non illustrée, d'accroître le courant dans l'enroulement d'excitation de l'alternateur de manière que les seuils ci-dessus soient à nouveau franchis aussi rapidement que possible par les crêtes des signaux de phase.

Z4 a pour objet de fournir sur la sortie S2 la tension requise pour le niveau logique haut. C3 évite les oscillations parasites au niveau de la sortie S2.

La partie du circuit construite autour de T11 et T12 a pour but de détecter si l'amplitude de la différence entre les tensions V_{ø1} et V_{ø2} a une valeur du même ordre de grandeur que la tension U_{B+com}, elle-même voisine de la tension en sortie d'alternateur. Les tensions de jonction base-émetteur de T12 et T11 définissent respectivement des tensions de seuil d'environ +0,6 volt et -0,6 volt de manière à vérifier si les tensions V_{ø1} et V_{ø2} passent par les niveaux +0,6 volt et U_{B+com}-0,6 volt.

Plus précisément, si la tension sur ø1 est supérieure à U_{B+com} diminuée de la tension de jonction émetteur-base de T11, alors T11 est bloqué. Si dans le même temps la tension sur ø2 est inférieure à la tension de jonction émetteur-base de T12, alors T12 est bloqué et S3 délivre un niveau logique haut, signalant l'absence de défaut. Si à un même instant l'une des deux conditions ci-dessus n'est pas remplie, alors T12 devient passant et S3 passe à un niveau logique bas.

Ainsi cette partie du circuit délivre sur sa sortie S3 un signal passant alternativement d'un niveau logique à l'autre lorsque l'amplitude des tensions phase V_{ø1} et V_{ø2} est suffisante. En revanche, si cette amplitude est insuffisante, le signal S3 reste en permanence au niveau haut, ce qui signale ce défaut.

Les composants Z5 et C4 ont des rôles équivalents à ceux des composants Z4 et C3 décrits plus haut.

Le transistor T8 a pour objet de mettre la ligne d'alimentation U_{B+com}, qui alimente les deux circuits construits autour de T9, T10 et T11, T12, respectivement, à une tension voisine de U_{B+} seulement lorsque le circuit de détection de phase a déterminé que l'alternateur est en rotation et met en service le circuit régulateur.

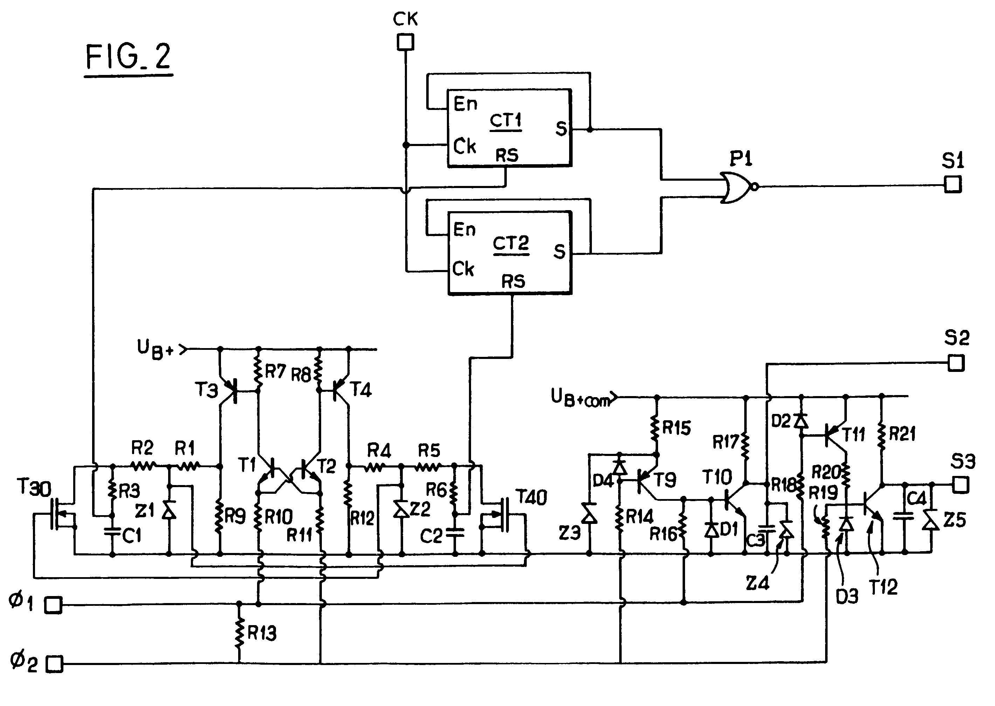

On va maintenant décrire en référence à la figure 2 une variante de réalisation de l'invention.

La partie de circuit construite autour de T1-T4, et les parties de circuit construites autour de T9, T10 et T11, T12, respectivement, sont réalisées comme sur la figure 1 et ne seront pas décrites à nouveau.

Dans cette variante, l'intégrateur de Miller est remplacé par un circuit de filtrage et d'immunisation contre les parasites de type différent. Plus précisément, le collecteur de T3 est en outre relié à une première borne d'une résistance R1 sont la seconde borne est reliée, de première part à une première borne d'une résistance R2, de deuxième part à la cathode d'une diode zéner Z1 et de troisième part à la grille d'un transistor T40 de type MOS-FET. La seconde borne de R2 est reliée au drain d'un autre transistor MOS-FET T30, et à une première borne d'une résistance R3. La seconde borne de R3 est reliée d'une part à l'entrée de remise à zéro RS d'un premier temporisateur constitué en l'espèce par un compteur binaire ascendant CT1, et d'autre part à une première borne d'un condensateur C1. A la masse sont reliées l'autre borne de C1, l'anode de Z1 et la source de T30.

Le collecteur de T4 est relié à une première borne d'une résistance R4 sont la seconde borne est reliée, de première part à une première borne d'une résistance R5, de deuxième part à la cathode d'une diode zéner Z2 et de troisième part à la grille de T30. La seconde borne de R5 est reliée au drain de T40 et à une première borne d'une résistance R6. La seconde borne de R6 est reliée d'une part à l'entrée de remise à zéro RS d'un second temporisateur constitué par un compteur binaire ascendant CT2, et d'autre part à une première borne d'un condensateur C2. A la masse sont reliées l'autre borne de C2, l'anode de Z2 et la source de T40.

Une borne d'entrée CK pour un signal d'horloge, sous forme par exemple d'un signal carré de fréquence appropriée, est reliée aux deux entrées d'horloge de comptage CK des compteurs CT1 et CT2. La sortie S de chaque compteur est constituée par l'une de ses lignes binaires parallèles de sortie, de poids bien déterminée, et elle est reliée à l'entrée d'activation En du compteur considéré, ceci afin de configurer les compteurs CT1 et CT2 en temporisateurs. Une porte NON-OU P1 reçoit par ailleurs en entrée les deux sorties S des compteurs, et sa sortie est reliée à une borne de sortie logique S1 du circuit.

On va maintenant expliquer en détail le fonctionnement du circuit de la figure 2.

Le circuit comparateur construit autour des transistors T1-T4, comme précédemment, ferme T3 ou T4 respectivement lorsque la valeur absolue de la tension entre phases excède 0,6 volt.

Les ensembles constitués par les composants R1, R2, R3, C1 et T30 d'une part, et R4, R5, R6, C2 et T40 d'autre part, constituent des filtres passe-bas disymétriques, basés sur une charge lente de C1 et C2 via les résistances R1, R2, R3 d'un côté et R4, R5, R6 de l'autre, et une décharge plus rapide de ces condensateurs, via seulement R3 et R6, respectivement, lorsque T30 et T40 sont fermés.

Plus précisément, lorsque l'alternateur est à l'arrêt, et en supposant initialement l'absence de parasites ou autres, la tension V_{ø2}-V_{ø1} est nulle. Les transistors T1 à T4 sont bloqués. C1 et C2 se déchargent donc lentement, respectivement via R3, R2, R1, R9 et R6, R5, R4, R12. Les tensions appliquées sur les entrées RS des deux compteurs sont donc en permanence des niveaux logiques bas. Les compteurs CT1 et CT2 délivrent donc sur leurs sorties S, éventuellement après une temporisation due au comptage, des niveaux logiques hauts, et la sortie S1 est au niveau bas, ce qui signale que le circuit régulateur associé à l'alternateur ne doit pas être mis en service.

Lorsque l'alternateur est en rotation, ou lors de l'existence de parasites radiofréquence, la tension V_{ø2}-V_{ø1} franchit alternativement les seuils de tension fixés par T1 et T2.

Dans un premier temps, lorsque par exemple V_{ø2}-V_{ø1} devient supérieure à +0,6 volt, alors T1 et T3 deviennent passants. C1 se charge lentement via R1, R2, R3. Un instant plus tard, T1 et T3 s'ouvrent à nouveau, puis T2 et T4 se ferment. La tension d'avalanche de la diode zéner Z2, par exemple de +5 volts, est alors appliquée à la grille de T30, qui se ferme pour décharger C1 rapidement, via seulement R3.

Ainsi, on comprend que le niveau de tension présent sur C1 varie en fonction de la fréquence et du rapport cyclique des périodes d'ouverture/fermeture de T3. De même, le niveau de tension sur C2 varie en fonction de ces mêmes critères quant à T4.

De la sorte, lorsque seuls des signaux parasites de haute fréquence, typiquement de quelques centaines de kilohertz, apparaissent sur les entrées phases, les durées de fermeture de T3 et T4 sont trop courtes pour faite monter la tension sur C1 ou C2 jusqu'à un niveau considéré comme un niveau logique haut par le compteur associé CT1 ou CT2. De même, lorsque ces parasites sont de brèves impulsions de tension espacées, donc de rapport cyclique faible, le niveau de tension sur C1 ou C2 ne monte là encore pas suffisamment. Les compteurs CT1 et CT2 ne sont donc pas remis à zéro et, comme décrit plus haut, la sortie de la porte P1 applique à la borne S1 un niveau logique bas. Le circuit régulateur reste donc inactif.

Au contraire, lorsque l'alternateur est en rotation, la tension sur C1 et la tension sur C2, du fait de la fréquence beaucoup plus basse du signal V_{ø2}-V_{ø1}, atteignent des valeurs qui sont pour les compteurs CT1 et CT2 des niveaux logiques hauts de remise à zéro. Les sorties S des deux compteurs restent en permanence à zéro car la remise à zéro des sorties S est prolongée pendant la durée de temporisation prévue pour être supérieure à la durée d'une alternance du signal phase, et ce pour les très faibles vitesses de rotation de l'alternateur. La sortie S1 est au niveau haut, ce qui signale que le circuit régulateur de l'alternateur doit être mis en service.

Par ailleurs, lorsque l'alternateur n'est pas en rotation et que l'une des liaisons de l'alternateur avec les entrées phases ø1 et ø2 est coupée, la tension V_{ø1}-V_{ø2} peut être supérieure à 0,6 volt car ces entrées phase ne sont plus amenées au même potentiel par le bobinage du stator de l'alternateur. On observe alors un comportement disymétrique des transistors T1, T3 d'une part et T2, T4 d'autre part. Par exemple, T1 et T3 peuvent être passants, tandis que T2 et T4 restent bloqués en permanence. Dans ce cas, Le compteur CT1 est remis à zéro, mais pas le compteur CT2. Les deux compteurs CT1 et CT2 délivrent donc en sortie respectivement un niveau logique bas et un niveau logique haut. La sortie S1 est donc au niveau logique bas et le circuit régulateur n'est pas mis en service. Ainsi, dans le cas d'une coupure de liaison phase à l'arrêt du moteur, le circuit selon l'invention permet d'éviter de façon fiable la mise en service du régulateur, qui provoquerait une décharge de la batterie.

En résumé, la mise en service du régulateur ne peut intervenir que lorsque l'alternateur est en rotation, et ce même lorsque les potentiels V_{ø1} et V_{ø2} des entrées phase sont perturbés par des parasites à haute fréquence ou par un défaut de liaison avec le bobinage du stator de l'alternateur.

Le filtrage réalisé par les condensateurs C1 et C2, complété par une temporisation au niveau des compteurs CT1 et CT2, permet d'assurer une excellente immunité vis-à-vis des parasites à haute fréquence, de durée brève, susceptibles d'apparaître sur les bornes ø1, ø2. En outre, le circuit de la figure 2, tout comme celui de la figure 1, est très facilement intégrable dans une puce unique de silicium, en n'y occupant qu'une surface limitée.

La porte P1 combine les signaux de sortie des deux compteurs, pour provoquer le passage du signal de sortie à la borne S1 au niveau bas dès qu'au moins l'un des deux compteurs n'est plus remis à zéro.

Bien entendu, la présente invention n'est nullement limitée à la forme de réalisation décrite ci-dessus et représentée sur les dessins, mais l'homme de l'art saura y apporter toute variante ou modification dans le cadre des revendications.

## Revendications

1. Circuit de détection de la tension entre phases d'un alternateur polyphasé pour commander la mise en service d'un régulateur de la charge d'une batterie d'un véhicule automobile par cet alternateur, le circuit comprenant des moyens de discrimination différentielle de l'amplitude de la tension entre un couple de signaux de phase (ø1,ø2), délivrés par l'alternateur, caractérisé en ce que les moyens de discrimination différentielle comprennent un couple de transistors (T1, T2), une première entrée des moyens de discrimination étant reliée à la base d'un premier transistor (T1) et à l'émetteur de l'autre transistor (T2), tandis qu'une seconde entrée des moyens de discrimination est reliée à la base du second transistor (T2) et à l'émetteur du premier transistor (T1), et les collecteurs des deux transistors (T1, T2) étant reliés aux entrées d'un circuit logique de type OU, chaque transistor constituant ainsi un moyen comparateur de la tension entre phases avec une même tension de seuil définie par sa tension de jonction émetteur/base respective, ladite tension de seuil ayant une faible valeur et ladite tension entre phases étant comparée avec cette tension de seuil avec des signes opposés, et la sortie dudit circuit logique de type OU délivrant un signal indiquant que la différence de tension entre les signaux de phases est supérieure en valeur absolue à ladite tension de seuil.

2. Circuit de détection selon la revendication 1, caractérisé en ce que chaque transistor (T1, T2) constituant un moyen comparateur a sa sortie reliée à un transistor de mise en forme de signaux (T3, T4).

3. Circuit selon l'une des revendications 1 et 2, caractérisé en ce qu'il comprend en outre, en association avec chaque transistor, un circuit de filtrage.

4. Circuit selon la revendication 3, caractérisé en ce que chaque circuit de filtrage comprend un condensateur (C1; C2) dont la charge à une première vitesse est provoquée par la fermeture du transistor associé (T1; T2) et dont la décharge, à une seconde vitesse sensiblement plus élevée, est provoquée par la fermeture de l'autre transistor (T2; T1) via un moyen interrupteur commandé (T30; T40).

5. Circuit selon la revendication 4, caractérisé en ce qu'il comprend en outre en association avec chaque circuit de filtrage un circuit de temporisation (CT1; CT2) dont une borne de sortie change d'état logique de façon durable seulement lorsque la tension aux bornes du condensateur (C1; C2) du circuit de filtrage associé excède une tension prédéterminée à une cadence supérieure à une cadence déterminée.

6. Circuit selon la revendication 5, caractérisé en ce que chaque circuit de temporisation comprend un compteur binaire (CT1; CT2) dont une entrée de remise à zéro reçoit la tension aux bornes du condensateur (C1; C2) du circuit de filtrage associé et dont une sortie est constituée par une sortie de bit de rang élevé.

7. Circuit selon la revendication 6, caractérisé en ce que les sorties des deux compteurs sont reliées aux deux entrées d'une porte logique (P1), dont la sortie est utilisée pour commander la mise en service du régulateur.

8. Circuit selon la revendication 7, caractérisé en ce que la porte logique est une porte NON-OU.

9. Circuit selon l'une des revendications 1 à 8, caractérisée en ce que les deux transistors (T1, T2) sont des transistors bipolaires.

10. Circuit selon l'une des revendications 1 à 9, caractérisé en ce qu'il comprend en outre des premiers moyens comparateurs additionnels (T9, T10) pour déterminer si une tension de signal de phase est inférieure à une troisième tension de seuil, proche de zéro, pendant qu'une tension d'un autre signal de phase est supérieure à une quatrième tension de seuil, proche de la moitié de la tension de batterie, de manière à provoquer l'accroissement du courant d'excitation dans l'alternateur lorsque cette condition n'est pas remplie.

11. Circuit selon la revendication 10, caractérisé en ce qu'il comprend en outre des seconds moyens comparateurs additionnels (T11, T12) pour déterminer si une tension de signal de phase est inférieure à une cinquième tension de seuil, proche de zéro, pendant qu'une tension d'un autre signal de phase est supérieure à une sixième tension de seuil, proche de la tension de batterie, à des fins de signalisation de défaut lorsque cette condition n'est pas remplie.

12. Circuit selon la revendication 11, caractérisé en ce que les premiers et seconds moyens comparateurs additionnels sont alimentés seulement lors de la mise en service du régulateur par le circuit de détection.

## Patentansprüche

1. Schaltung für die Erfassung der Zwischenphasenspannung eines Mehrphasengenerators zur Steuerung der Einschaltung eines Reglers für die Ladung einer Kraftfahrzeugbatterie durch diesen Generator, wobei die Schaltung Mittel zur differentiellen Unterscheidung der Amplitude der Spannung zwischen einem durch den Generator abgegebenen Phasensignalpaar (ø1, ø2) umfaßt, **dadurch gekennzeichnet**, daß die Mittel zur differentiellen Unterscheidung ein Paar Transistoren (T1, T2) enthalten, wobei ein erster Eingang der Unterscheidungsmittel mit der Basis eines ersten Transistors (T1) und mit dem Emitter des anderen Transistors (T2) verbunden ist, während ein zweiter Eingang der Unterscheidungsmittel mit der Basis des zweiten Transistors (T2) und dem Emitter des ersten Transistors (T1) verbunden ist, und wobei die Kollektoren der beiden Transistoren (T1, T2) mit den Eingängen einer logischen ODER-Schaltung verbunden sind, so daß jeder Transistor ein Vergleichsmittel für den Vergleich der Zwischenphasenspannung mit einer gleichen Schwellenspannung bildet, die durch seine jeweilige Spannung am Emitter-Basis-Übergang definiert ist, wobei die besagte Schwellenspannung einen niedrigen Wert hat und die besagte Zwischenphasenspannung mit dieser Schwellenspannung mit umgekehrten Vorzeichen verglichen wird und wobei der Ausgang der besagten logischen ODER-Schaltung ein Signal liefert, das anzeigt, daß die Spannungsdifferenz zwischen den Phasensignalen bezogen auf den Absolutwert größer als die besagte Schwellenspannung ist.

2. Erfassungsschaltung nach Anspruch 1 , **dadurch gekennzeichnet,** daß jeder Transistor (T1, T2), der ein Vergleichsmittel bildet, an seinem Ausgang mit einem Transistor für die Signalaufbereitung (T3, T4) verbunden ist.

3. Schaltung nach einem der Ansprüche 1 und 2 , **dadurch gekennzeichnet**, daß sie außerdem in Verbindung mit jedem Transistor eine Filterschaltung umfaßt.

4. Schaltung nach Anspruch 3 , **dadurch** **gekennzeichnet**, daß jede Filterschaltung einen Kondensator (C1; C2) umfaßt, dessen Aufladung mit einer ersten Geschwindigkeit durch das Schließen des zugehörigen Transistors (T1; T2) bewirkt wird und dessen Entladung mit einer wesentlich höheren zweiten Geschwindigkeit durch das Schließen des jeweils anderen Transistors (T2; T1) über ein gesteuertes Schaltermittel (T30; T40) herbeigeführt wird.

5. Schaltung nach Anspruch 4 , **dadurch** **gekennzeichnet**, daß sie außerdem in Verbindung mit jeder Filterschaltung eine Verzögerungs-schaltung (CT1; CT2) umfaßt, von der ein Ausgang seinen logischen Zustand dauerhaft erst dann ändert, wenn die Anschlußspannung des Kondensators (C1; C2) der zugehörigen Filterschaltung eine vorbestimmte Spannung mit einer zeitlichen Abfolge überschreitet, die schneller als eine bestimmte Abfolge ist.

6. Schaltung nach Anspruch 5 , **dadurch** **gekennzeichnet** , daß jede Verzögerungsschaltung einen Binärzähler (CT1; CT2) umfaßt, von dem ein Nullstellungseingang die Anschlußspannung des Kondensators (C1; C2) der zugehörigen Filterschaltung erhält und von dem ein Ausgang aus einem werthohen Bitausgang besteht.

7. Schaltung nach Anspruch 6 , **dadurch** **gekennzeichnet** , daß die Ausgänge der beiden Zähler mit den beiden Eingängen eines Logikgatters (P1) verbunden sind, dessen Ausgang für die Steuerung der Einschaltung des Reglers benutzt wird.

8. Schaltung nach Anspruch 7 , **dadurch** **gekennzeichnet** , daß es sich bei dem Logikgatter um ein NOR-Glied handelt.

9. Schaltung nach einem der Ansprüche 1 bis 8 , **dadurch gekennzeichnet** , daß die beiden Transistoren (T1, T2) Bipolartransistoren sind.

10. Schaltung nach einem der Ansprüche 1 bis 9, **dadurch gekennzeichnet** , daß sie außerdem erste zusätzliche Vergleichsmittel (T9, T10) umfaßt, um festzustellen, ob eine Phasensignalspannung kleiner als eine dritte Schwellenspannung nahe Null ist, während eine Spannung eines anderen Phasensignals größer als eine vierte Schwellenspannung nahe der halben Batteriespannung ist, so daß die Erhöhung des Erregerstroms im Generator bewirkt wird, wenn diese Bedingung nicht erfüllt ist.

11. Schaltung nach Anspruch 10 , **dadurch** **gekennzeichnet** , daß sie außerdem zweite zusätzliche Vergleichsmittel (T11, T12) umfaßt, um festzustellen, ob eine Phasensignalspannung kleiner als eine fünfte Schwellenspannung nahe Null ist, während eine Spannung eines anderen Phasensignals größer als eine sechste Schwellenspannung in der Nähe der Batteriespannung ist, im Hinblick auf eine Fehleranzeige, wenn diese Bedingung nicht erfüllt ist.

12. Schaltung nach Anspruch 11 , **dadurch** **gekennzeichnet** , daß die ersten und zweiten zusätzlichen Vergleichsmittel nur bei der Einschaltung des Reglers durch die Erfassungsschaltung mit Strom versorgt werden.

## Claims

1. A detection circuit for detecting the voltage between phases of a polyphase alternator for the purpose of controlling the putting into operation of a regulator for regulating the charging of a motor vehicle battery by said alternator, the circuit comprising differential discrimination means for the amplitude of the voltage between a pair of phase signals (ø1, ø2) delivered by the alternator, the circuit being characterized in that the differential discrimination means comprise a pair of transistors (T1, T2), a first input of the discrimination means being connected to the base of a first transistor (T1) and to the emitter of the other transistor (T2), and a second input of the discrimination means is connected to the base of the second transistor (T2) and to the emitter of the first transistor (T1), and the collectors of the two transistors (T1, T2) being connected to the inputs of an OR type logic circuit, each transistor thus constituting means for comparing the inter-phase voltage with the same threshold voltage defined by their respective emitter-base junction voltages, said threshold voltage being of small value and said inter-phase voltage being compared with said threshold voltage with opposite signs, and the output of said OR type logic circuit delivering a signal indicating that the voltage difference between the phase signals is greater in absolute value than said threshold voltage.

2. A detection circuit according to claim 1, characterized in that each of the transistors (T1, T2) constituting the comparator means has its output connected to a signal shaping transistor (T3, T4).

3. A circuit according to claim 1 or 2, characterized in that it further includes a filter circuit associated with each transistor.

4. A circuit according to claim 3, characterized in that each filter circuit comprises a capacitor (C1; C2) charged at a first rate by the associated transistor (T1; T2) being switched on and discharged via controlled switch means (T30; T40) at a significantly higher second rate by the other transistor (T2; T1) being switched on.

5. A circuit according to claim 4, characterized in that it further includes a time delay circuit (CT1; CT2) associated with each filter circuit, an output terminal of each time delay circuit changing logic state durably only when the voltage across the terminals of the capacitor (C1; C2) in the associated filter circuit exceeds a predetermined voltage at a rate that is greater than a determined rate.

6. A circuit according to claim 5, characterized in that each time delay circuit comprises a binary counter (CT1; CT2) having a reset to zero input that receives the voltage across the terminals of the capacitor (C1; C2) of the associated filter circuit, and whose output is constituted by a high rank bit output.

7. A circuit according to claim 6, characterized in that the outputs of the two counters are connected to two inputs of a logic gate (P1) whose output is used for putting the regulator into operation.

8. A circuit according to claim 7, characterized in that the logic gate is a NOR gate.

9. A circuit according to any one of claims 1 to 8, characterized in that the two transistors (T1, T2) are bipolar transistors.

10. A circuit according to any one of claims 1 to 9, characterized in that it further includes first additional comparator means (T9, T10) for determining whether a phase signal voltage is below a third threshold voltage close to zero while another phase signal voltage is greater than a fourth threshold voltage close to half the battery voltage, so as to cause the excitation current in the alternator to be increased whenever this condition is not satisfied.

11. A circuit according to claim 10, characterized in that it further includes second additional comparator means (T11, T12) for determining whether a phase signal voltage is less than a fifth threshold voltage close to zero while another phase signal voltage is greater than a sixth threshold voltage close to the battery voltage, for the purpose of signalling a fault when said condition is not satisfied.

12. A circuit according to claim 11, characterized in that the first 5 and second additional comparator means are powered only while the regulator circuit is being put into operation by the detection circuit.
